Europäisches Patentamt

European Patent Office

Office européen des brevets

(11) Publication number: **0 111 097**
**B1**

(12) **EUROPEAN PATENT SPECIFICATION**

(45) Date of publication of patent specification: **27.05.87**

(51) Int. Cl.⁴: **H 01 L 21/76, H 01 L 29/06**

(21) Application number: **83110129.0**

(22) Date of filing: **11.10.83**

(54) **Method for making semiconductor devices having a thick field dielectric and a self-aligned channel stopper.**

(30) Priority: **08.12.82 US 447852**

(43) Date of publication of application:
**20.06.84 Bulletin 84/25**

(45) Publication of the grant of the patent:
**27.05.87 Bulletin 87/22**

(84) Designated Contracting States:
**DE FR GB**

(56) References cited:
**DE-A-3 031 170**
**US-A-4 140 547**
**US-A-4 144 101**
**US-A-4 219 379**
**US-A-4 347 654**

**IBM TECHNICAL DISCLOSURE BULLETIN,
volume 25, no. 7A, December 1982 (NEW
YORK, US) P.E. BAKEMAN et al. "Recessed
oxide isolation with offset field doping", pages
3498, 3499**

(73) Proprietor: **International Business Machines
Corporation
Old Orchard Road
Armonk, N.Y. 10504 (US)**

(72) Inventor: **Badami, Dinesh Arvindlal
34 Rivercove Road
Williston Vermont 05495 (US)**
Inventor: **Bergendahl, Albert Stephen
Rd2 Box 467
Underhill Vermont 05489 (US)**
Inventor: **Hakey, Mark Charles
P.O. Box 212
Milton Vermont 05468 (US)**

(74) Representative: **Barth, Carl Otto et al
IBM Deutschland GmbH Patentabteilung
Schönaicher Strasse 220
D-7030 Böblingen (DE)**

## Description

This invention relates to a method of forming high density semiconductor devices and more particularly to a method of forming a semiconductor device in which device isolation is provided by a thick field dielectric having a self-aligned channel stopper.

An important aspect of semiconductor devices is the means provided for electrically isolating adjacent devices on the same substrate. The fabrication step or steps that produce the isolation affects the spacing between devices (i.e., the device packing density) as well as the electrical characteristics of the device. The presence of doped areas beneath the isolation regions is often referred to as a "parasitic channel stopper" doping and is important for eliminating unwanted conduction due to inversion under the field isolation when lightly doped substrates are employed. The use of lightly doped substrates has been practiced in order to reduce diffused line capacitance which degrades performance as well as reducing hot electron effects which degrade reliability. Along with the channel stopper doping under the field isolation, there is also normally present channel doping in the device areas in order to adjust the gate threshold voltage to an acceptable operating level.

One technique employed to provide the channel stopper or "field" doping is to use an extra masking step. This approach has been described by R. J. Whittier, "Semiconductor Memories: The Impact and Momentum of Current Technology", IEEE Electro 76 Meeting Tech. Digest. Session 33, p. 2, Boston, May 11, 1976. The resultant isolation structure provides a doping region which is not self-aligned to the isolation material (i.e., silicon dioxide). Consequently this technique suffers from the disadvantage of requiring additional area, thus reducing the device packing density, as well as the additional masking operation. The resist regions used to define the isolation regions are located regions used to define the isolation regions rather than over the device areas. This technique is sometimes referred to as non-recessed or "planar" isolation.

Another isolation technique is described in the aforementioned article by Whittier which provides self-alignment of the field doping to the field isolation. This technique is sometimes referred to as selective or local or semi-recessed oxidation and is described by P. Richman, U.S. Pat. 3 751 722, 7 Aug. 1973, and by E. Kooi, U.S. Pat. 3 752 711, 14 Aug. 1973. The semi-recessed oxide isolation structure has a number of attractive features including self-alignment of the field doping and field isolation, the use of only one masking step, and improved planarity. However, this procedure still presents a number of disadvantages. For instance, the presence of the oxidation barrier layer such as the nitride over the device regions may cause strain and thus permanently damage the device regions during the thermal oxidation required to form the field isolation. In addition, the device area is undesirably reduced and the field isolation is undesirably increased by lateral oxidation or what is commonly termed in the art as the "Bird's Beak Effect" and described by E. Basscous, H. N. Yu, and V. Maniscalco, "The Formation of Bird's Beak in Si Structure with Recessed $SiO_2$", Extended Abstracts, pp. 457—458. ECS Fall Meeting, Dallas, Oct. 5—10, 1975. Moreover, the procedure requires additional layers of silicon dioxide (substrate protection), silicon nitride (oxidation barrier layer), and silicon dioxide (defining oxide layer) in order to protect and define the device regions. Furthermore, the removal of the defining oxide layer affects the thickness of the recessed oxide or its lateral extent, particularly when a relatively thick oxide layer is required as in a fully-recessed oxide isolation region formed as described, for example, by R. H. Dennard, V. L. Rideout, and E. J. Walker in U.S. Pat. 3 899 363, 12 Aug. 1975.

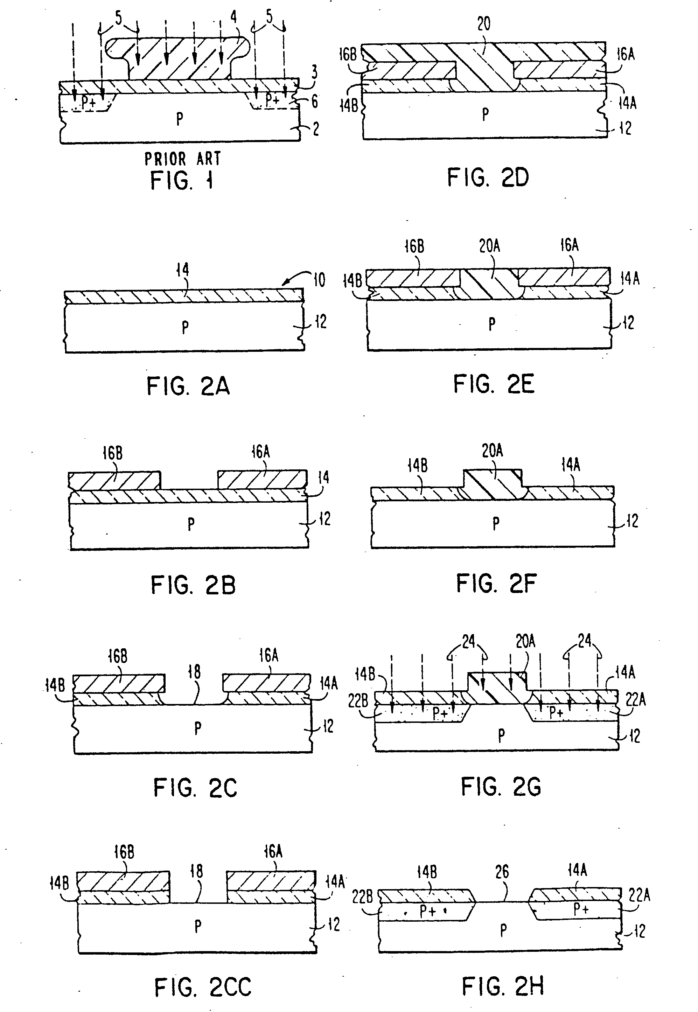

A process for providing self-aligned doping regions by ion implantation and lift-off is described in U.S. Patent 4 144 101. The structure utilized in this process is shown in Fig. 1. The patent teaches a process using complementary masks including a resist mask 4 to define the implanted channel stopper formed by ion implantation 5. In this process, the resist mask 4 is positioned on top of a silicon dioxide layer 3. While this process is effective in providing self-aligned doping regions by ion implantation, it is not suitable for devices that require both thick field isolation and thin device dielectric ($SiO_2$) regions because of required device isolation.

The IBM Technical Disclosure Bulletin, October 1979, Vol. 22, No. 5, page 2133, teaches a two-resist image-reversal technique in which a first resist image pattern is defined and a second photoresist is applied filling the originally developed areas. The second resist is removed until the original resist is exposed. The first resist is then removed to leave a portion of the second resist corresponding to a negative image of the first pattern. No conventional semiconductor processing is taught to take place between the resist processing steps.

However, the above described methods and structures still do not satisfy all needs and leave room for improvement. This invention intends to provide such an improvement.

Basically, a method for forming semiconductor devices, for example FET devices, in which the field oxide and ion implanted channel stopper are self-aligned is disclosed. The method includes the steps of growing or depositing a thick field oxide on a semiconductor wafer; applying exposing, and developing a photoresist pattern to expose active device areas; etching the field oxide through the openings in the photoresist pattern; applying a self levelling masking material such as a polymer or photoresist over the etched photoresist covered field oxide; removing the self levelling masking material that is on top of the photoresist pattern; removing all of the photoresist pattern to leave a plug of masking material extending above the surface of the field oxide only in the area of the field oxide previously etched; ion implanting channel stopper ions into and through the field oxide; and removing the masking material.

This process provides a structure with the advantage of improved circuit density due to reduced process biases and less lateral diffusion. The method itself has fewer steps than the prior art self-aligned processes.

For further understanding of the invention and of the objects and advantages thereof, reference is made to the following detailed description and to the accompanying drawings in which:

FIG. 1 illustrates a planar isolation with a self-aligned field doping prepared by a prior art procedure; and

FIGS. 2A—2H are cross sectional views illustrating various stages of fabrication according to the present invention.

For convenience, the discussion of the unique fabricating steps of the present invention is directed to providing field doping in a planar silicon dioxide isolation process. It is understood, of course, that the steps are applicable for providing ion-implanted regions beneath preselected regions of an existing layer on a substrate when the aspects of self-alignment along with minimal masking steps are desired. In addition, the discussion of the fabrication steps is directed to the preferred aspect of employing a p-type silicon substrate as the semiconductive substrate and a p-type impurity as the implanted dopant species. This leads to the n-channel FET technology. Accordingly, it is understood that an n-type substrate and n-type implanted dopant impurities can be employed according to the present invention in the p-channel FET technology.

Referring to Fig. 2A, there is shown a fragment of initial structure generally shown as 10. A p-type silicon substrate 12 such as one having about 10—15 ohm-cm resistivity and having any desired crystal orientation (e.g., $\langle 100 \rangle$). The substrate can be prepared by slicing and polishing a p-type silicon boule grown in the presence of the p-type dopant such as boron following conventional crystal growth techniques. Other p-type dopants for silicon include aluminium, gallium, and indium.

Next, a relatively thin silicon dioxide layer 14 of about 0,15 to about 1 µm (about 1500 to about 10 000 Å) and preferably about 0,5 to about 0,54 µm (about 5000 to about 5400 Å) is grown by wet thermal oxidation such as oxidation at about 900° to 1000°C in the presence of steam. This is referred to as the initial field oxide thickness as it is not the final field oxide thickness. This oxide might also be a chemical vapor deposited film of $SiO_2$.

Next, as shown in Fig. 2B, resist is applied and exposed to radiation incident through a masking pattern to provide the pre-selected pattern 16A and 16B in the resist layer. The resist layer is generally about 1,0 to about 2,4 µm (about 10 000 to about 24 000 Å) thick, preferably about 1,8 µm

(18 000 Å) thick. A typical resist material is a diazo type positive photoresist such as AZ 1350® which is spun onto the substrate and baked at about 80 to 95°C for 5 for 15 minutes. The sample is exposed to radiation directly via electron beam or photon exposure using a photo mask to provide the desired pattern of resist. The resist pattern is developed by soaking in a solution of aqueous base such as 0.1 to 0.3M KOH for several minutes.

As shown in Fig. 2C, the field oxide layer 14 that is exposed by the pattern 16A and 16B in the resist layer is etched away with plasma or by reactive ion etching means to form field oxide regions 14A and 14B. The area of silicon layer 12 exposed by the etching of the field oxide layer 14 provides a future gate or diffusion area 18. As will be indicated later, the field stopper ion implant profile at the edge of the field oxide may be controlled by altering the slope and undercut of films 16A, 16b and 14A, 14B of Fig. 2C. These shapes may be altered by baking to soften 16A, 16B above its glass transition temperature of about 105 to 120°C and varying the etch process selectivities to films 16A, 16B and 14A, 14B. A shape with no undercut is shown in Fig. 2CC.

As shown in Fig. 2D, a layer 20 of a self levelling masking material such as a polymer or photoresist is applied over the photoresist pattern 16A and 16B and etched field oxide 14. An example of a suitable polymer is polymethyl methacrylate dissolved in chlorobenzene. The thickness of this photoresist layer is not critical and is of the order of 0,25 to 1,0 µm (2500 to 10 000 Å) above the top surface of the first resist pattern 16A, 16B. The photoresist material for layer 20 must be one that does not intermix or dissolve the resist pattern 16A and 16B. The resist layer 20 fills the opening between resist 16A, the holes that have been etched in the oxide layer 14. A polymethyl methacrylate dissolved in chlorobenzene is such a photoresist or polymer.

As shown in Fig. 2E, the second resist layer 20 has been either back either by reactive ion or plasma etching to expose the first resist pattern 16A and 16B. This etching step leaves a plug 20A between resist pattern 16A and 16B and field oxide 14 that had been etched away. The next step as shown in Fig. 2F is to dissolve or develop away the first resist pattern 16A and 16B leaving the field oxide etched regions 14A and 14B. This leaves a plug 20A having a thickness substantially thicker than the field oxide regions 14A and 14B.

Next, as shown in Fig. 2G, a p-type dopant such as boron ions 24 is ion implanted. Boron ions can be implanted, for instance at about 150 KeV energy at a dosage of about $5 \cdot 10^{12}$ atoms per cm$^2$ providing a field surface doping of about 2 ohm-cm. Boron ions at 150 KeV energy have a range of about 0,4 µm (4000 Å) and a standard deviation of about 0,07 µm (700 Å). In this step, the resist plug 20A acts as an implantation mask in that the ions will not pass through the resist plug 20A, but will pass through field oxide regions 14A and 14B. Boron ions 24 provide parasitic channel stopper regions 22A and 22B.

As shown in Fig. 2H, the resist plug 20A is removed by conventional means such as by dissolving in an etchant such as a hot solution of concentrated sulfuric and nitric acids or plasma ashing with $O_2$ gas mixtures. This leaves area 26 that is used for future gate or diffusion areas.

The advantages of this process include improved circuit density due to less lateral diffusion than the current semi-ROX or non-self-alignment process as well as the elimination of the problems inherently associated with recessed oxide type isolation processes. In addition, this process is a much simpler process that lends itself to being used in a manufacturing mode. Appropriate automated coating and etching apparata for said process are available and in use.

## Claims

1. A method of providing device isolation regions in a semiconductor substrate (12), said isolation regions consisting of a field dielectric layer (14) on said substrate (12) and an aligned channel stopper region (22A, B) in said substrate below said field dielectric layer, comprising the steps of:
providing said field dielectric layer (14) on said substrate (12),
providing a patterned first masking layer (16A, B) on said field dielectric layer (14) covering areas intended to be isolation regions, and exposing areas intended to be active device regions,
etching the exposed areas of the field dielectric layer (14) to expose said active device regions of the substrate,
forming a complementary patterned second masking layer (20, 20A) over said etched areas,
removing the first masking layer (16A, B), and
ion-implanting channel stopper regions (22A, B) under the remaining field dielectric layer using said second layer (20) as implantation mask.

2. The method of claim 1, whereby said substrate is silicon, in particular p-type silicon.

3. The method of claim 1, whereby said dielectric layer (14) is silicon dioxide obtained by wet thermal oxidation or chemical vapor deposition.

4. The method of claim 1, whereby said patterned first masking layer (16A, B) is a resist material that is more sensitive to the exposure or developing technique than the resist material used for the complementary second masking layer (20, 20A).

5. The method of claim 1 comprising the steps of:
growing said field dielectric layer (14) on said substrate (12),
applying, exposing and developing a photoresist pattern as said first masking layer (16A, B) to expose areas of said dielectric layer,
baking said photoresist pattern,
etching said exposed dielectric areas to expose said active device regions of the substrate (12),
applying a layer of self-levelling photoresist as said second masking layer (20) over said exposed active device regions and said baked photoresist pattern,
removing the self-levelling photoresist material that is on top of said baked photoresist pattern,
dissolving said baked photoresist pattern to leave a plug (20A) of said self-levelling photoresist extending above the surface of said dielectric layer,
ion-implanting said channel stopper region (22A, B) through said dielectric layer into said substrate, and
removing said plug of self-levelling photoresist.

## Patentansprüche

1. Verfahren zur Herstellung von Vorrichtungs-Isolationsbereichen in einem Halbleitersubstrat (12), wobei diese Isolationsbereiche aus einem Felddielektrikum (14) auf dem Substrat (12) und einem ausgerichteten Kanalbegrenzungsbereich (22A, B) im Substrat unterhalb des Felddielektrikums bestehen, folgende Schritte umfassend:
Vorsehen des Felddielektrikums (14) auf dem Substrat (12),
Vorsehen einer ersten Muster-Maskierungsschicht (16A, B) auf dem Felddielektrikum (14) zum Abdecken von Zonen für die Isolationsbereiche, sowie Freilegen von Zonen als aktive Vorrichtungsbereiche,
Ätzen der freigelegten Bereiche des Felddielektrikums (14) zum Freilegen der aktiven Vorrichtungsbereiche des Substrats,
Vorsehen einer komplementären zweiten Muster-Maskenschicht (20, 20A) über den geätzten Bereichen,
Entfernen der ersten Maskierungsschicht (16A, B), und
Ionenimplantieren der Kanalbegrenzungsbereiche (22A, B) unter dem vergleibenden Felddielektrikum, wobei die zweite Schicht (20) als Implantationsmaske verwendet wird.

2. Verfahren nach Anspruch 1, wobei es sich bei dem Substrat um Silizium, insbesondere um P-Silizium handelt.

3. Verfahren nach Anspruch 1, wobei es sich bei dem Dielektrikum (14) um Siliziumdioxid handelt, welches durch thermisches Naßoxidieren oder chemisches Abscheiden aus der Dampfphase erzielt wird.

4. Verfahren nach Anspruch 1, wobei es sich bei der ersten Mustermaskierungsschicht (16A, B) um ein Photolackmaterial handelt, welches auf die Belichtung- oder Entwicklungstechnik empfindlicher anspricht als das Photolackmaterial, welches für die komplementäre zweite Maskenschicht (20, 20A) verwendet wird.

5. Verfahren nach Anspruch 1, folgende Schritte umfassend:
Aufwachsen des Felddielektrikums (14) auf dem Substrat (12),
Aufbringen, Belichten und Entwickeln eines Photoresistmusters als erste Maskierungsschicht (16A, B) zum Freilegen von Bereichen des Dielektrikums,

Härten des Photoresistmusters,

Ätzen der freigelegten Dielektrikumzonen zum Freilegen der aktiven Vorrichtungsbereiche des Substrats (12),

Aufbringen einer Schicht aus nivellierendem Photoresist als zweite Maskierungsschicht (20) über den freigelegten aktiven Vorrichtungsbereichen und dem gehärteten Photoresistmuster,

Entfernen des nivellierenden Photoresistmaterials auf der Oberfläche des gehärteten Photoresistmusters,

Ablösen des gehärteten Photoresistmusters unter Verbleib einer Restfläche (20A) des nivellierenden Photoresistmaterials über der Oberfläche der dielektrischen Schicht,

Ionenimplantation des Kanalbegrenzerbereichs (22A, B) durch das Dielektrikum in das Substrat, sowie

Entfernung der Restfläche des nivellierenden Photoresistmaterials.

**Revendications**

1. Procédé d'obtention de régions d'isolement de dispositif dans un substrat semi-conducteur (12), lesdites régions d'isolement étant constituées d'une couche de diélectrique de champ (14) sur ledit substrat (12) et d'une région d'interruption de canal alignée (22A, B) dans ledit substrat au-dessous de la dite couche de diélectrique de champ, caractérisé en ce qu'il comprend les opérations consistant:

à créer ladite couche de diélectrique de champ (14) sur ledit substrat (12),

à créer une première couche de masquage à dessin (16A, B) sur ladite couche de diélectrique de champ (14) couvrant des zones destinées à devenir des régions d'isolement et exposant des zones destinées à devenir des régions de dispositif actif,

à attaquer les zones exposées de la couche de diélectrique de champ (14) pour exposer lesdites régions de dispositif actif du substrat,

à former une deuxième couche de masquage à dessin complémentaire (20, 20A) par-dessus lesdites zones attaquées,

à enlever la première couche de masquage (16A, B), et

à implanter ioniquement des régions d'interruptions de canal (22A, B) sous la couche de diélectrique de champ restante en utilisant ladite deuxième couche (20) comme masque d'implantation.

2. Procédé selon la revendication 1, caractérisé en ce que ledit substrat est du silicium, en particulier du silicium de type p.

3. Procédé selon la revendication 1, caractérisé en ce que ladite couche de diélectrique (14) est du dioxyde de silicium obtenu par oxydation thermique humide ou par dépôt chimique de vapeur.

4. Procédé selon la revendication 1, caractérisé en ce que ladite première couche de masquage à dessin (16A, B) est un matériau de réserve qui est plus sensible à la technique d'exposition ou de développement que le matériau de réserve utilisé pour la deuxième couche de masquage complémentaire (20, 20A).

5. Procédé selon la revendication 1, caractérisé en ce qu'il comprend les opérations consistant:

à faire croître ladite couche de diélectrique de champ (14) sur ledit substrat (12),

à appliquer, exposer et développer un dessin de matériau de réserve photo-sensible constituant ladite première couche de masquage (16A, B) pour exposer des zones de ladite couche de diélectrique,

à cuire ledit dessin de matériau de réserve photosensible,

à attaquer lesdites zones de diélectrique exposées pour exposer lesdites régions de dispositif actif du substrat (12),

à appliquer une couche de matériau de réserve photo-sensible à auto-nivellement constituant ladite deuxième couche de masquage (20) par-dessus lesdites régions de dispositif actif exposées et ledit dessin de matériau de réserve photosensible cuit,

à enlever le matériau de réserve photo-sensible à auto-nivellement qui se trouve au-dessus dudit dessin de matériau de réserve photo-sensible cuit,

à dissoudre ledit dessin de matériau de réserve photo-sensible cuit pour laisser un bouchon (20A) dudit matériau de réserve photo-sensible à auto-nivellement dépassant au-dessus de la surface de ladite couche de diélectrique,

à implanter ioniquement ladite région d'interruption de canal (22A, B) dans ledit substrat à travers ladite couche de diélectrique, et

à enlever ledit bouchon de matériau de réserve photo-sensible à auto-nivellement.

PRIOR ART
FIG. 1

FIG. 2A

FIG. 2B

FIG. 2C

FIG. 2CC

FIG. 2D

FIG. 2E

FIG. 2F

FIG. 2G

FIG. 2H